# EUROPEAN PATENT APPLICATION

(11) **EP 4 227 445 A1**
(43) Date of publication of application: **16.08.2023**
(21) Application number: 21877041.0
(22) Date of filing: 11.10.2021
(51) Int. Cl.: C30B 15/00, C30B 15/26

(54) **CRYSTAL GROWTH DEVICE AND METHOD**

(30) Priority: 10.10.2020 CN 202011079436
(71) Applicant: Zhonghuan Advanced Semiconductor Materials Co., Ltd., Wuxi, Jiangsu 214203 (CN)
(72) Inventor: LIU, Qi, Wuxi, Jiangsu 214203 (CN); HUANG, Mo, Wuxi, Jiangsu 214203 (CN); CHEN, Yi, Wuxi, Jiangsu 214203 (CN); FENG, Houkun, Wuxi, Jiangsu 214203 (CN); FENG, Shen, Wuxi, Jiangsu 214203 (CN)
(74) Representative: Penza, Giancarlo
(86) International application number: PCT/CN2021/123121
(87) International publication number: WO 2022/073524

(57) **Abstract**

Provided are an ingot growth device and growth method. The ingot growth device includes a furnace body, a crucible, a cooling jacket and a reflector, wherein the cooling jacket is arranged inside the furnace body to cool the ingot, the reflector is arranged on a periphery of the cooling jacket, the reflector includes an upper reflector part and a lower reflector part, the upper reflector part is cylindrical and surrounds the cooling jacket, the lower reflector part is arranged at a lower end of the upper reflector part and is located on a lower side of the cooling jacket, the lower reflector part is of a hollow circular truncated cone structure with a large top and a small bottom, a groove is formed on an inner peripheral wall of the circular truncated cone structure, the top of the groove penetrates through the circular truncated cone structure, and the cooling jacket moves along an axial direction of the crucible. The ingot growth device may fine-tune a temperature gradient at a solid-liquid interface, thereby growing an ingot with a width defect-free region.

## Description

### Cross-Reference to Related Application

The present invention claims the priority of Chinese Patent Application 202011079436.6, filed on October 10, 2020, and entitled "Ingot Growth Device and Growth Method", the entire contents of which are herein incorporated by reference.

### Technical Field

The present invention relates to the technical field of semiconductors, and in particular, to an ingot growth device and growth method.

### Background

According to the theory proposed by Voronkov, if intrinsic defects generated by growth need to be eliminated during the ingot growth process, an axial temperature gradient of the Ingot at a solid-liquid interface needs to maintain uniformity along the radial direction, and the ratio V/G of a Ingot growth speed to the axial temperature gradient at the solid-liquid interface must be controlled within a certain range, wherein V represents the ingot growth speed, G represents the temperature gradient at the solid-liquid interface, and when V/G is greater than a certain critical value, the internal defects of the ingot tend to be a vacancy type (Vacancy Defect), and on the contrary, when V/G is less than a certain critical value, the internal defects of the ingot tend to be an insertion type (Interstitial Defect). Therefore, it is necessary to decrease a growing speed or increase the temperature gradient at the solid-liquid interface, so as to reduce internal defects of the ingot, so that the V/G value is very close to the critical value. However, it is difficult to control the temperature gradient at the solid-liquid interface in the prior art, therefore it is difficult to pull an ingot with defect-free regions.

However, in an actual Ingot production process, the temperature gradient at the interface is finely adjusted generally by means of adjusting the gap (gap) between the solid-liquid interface and a reflector, so as to control the size of a diameter. However, the position of the reflector is fixed, and only the position of the melt level is adjusted, resulting in a vibration of the melt level at the interface, which affects a yield of growing the ingot.

The above information disclosed in the background art is only used to enhance the understanding of the background art of the techniques described herein, and therefore, some information may be included in the background art, and the information is not formed in the prior art of China for those skilled in the art.

### Summary

In order to solve the above problems, some embodiments of the present invention provide an ingot growth device and growth method, which can fine-tune a temperature gradient at a solid-liquid interface, and adjust the diameter at an equal-diameter stage in time.

In order to achieve the above objectives, according to one aspect of the present invention, an ingot growth device is provided, including a furnace body, a crucible, a cooling jacket and a reflector, wherein the crucible is arranged inside the furnace body for containing melt; the cooling jacket is arranged inside the furnace body to cool the ingot, the cooling jacket is located above the crucible and is on a horizontal plane perpendicular to the central axis of the crucible, and an orthographic projection of the cooling jacket is located in the outer contour of the orthographic projection of the crucible; the reflector is arranged on a periphery of the cooling jacket, the reflector is filled between the ingot and the crucible, the reflector includes an upper reflector part and a lower reflector part, the upper reflector part is cylindrical and surrounds the cooling jacket, the lower reflector part is arranged at a lower end of the upper guide cylinder part and is located on a lower side of the cooling jacket, the lower reflector part is of a hollow circular truncated cone structure with a large top and a small bottom, a groove is formed on an inner peripheral wall of the circular truncated cone structure, a top of the groove penetrates through the circular truncated cone structure, a side wall of the groove is a cylindrical surface, and a bottom wall of the groove is an annular surface; and the cooling jacket moves along an axial direction of the crucible.

In some embodiments, an axial distance between the cooling jacket and the bottom wall of the groove in the crucible is 13mm -93mm.

In some embodiments, the cooling jacket includes a shell and a water flow channel located inside the shell, and a width of the water flow channel is 5mm-15mm.

In some embodiments, the lower reflector part is formed a rotator, and a longitudinal section of the lower reflector part includes a first line segment, a second line segment, a third line segment, a fourth line segment and a fifth line segment, which are connected in sequence, wherein the first line segment corresponds to an outer peripheral wall of the circular truncated cone structure and is formed into an oblique line segment, the fourth line segment corresponds to the bottom wall of the groove and is parallel to the second line segment, and the fifth line segment corresponds to the side wall of the groove and is vertically arranged with the third line segment.

In some embodiments, the second line segment and the fourth line segment intersect perpendicularly to the third line segment, respectively.

In some embodiments, an included angle θ between the first line segment and the central axis of the crucible is 40°-80°.

In some embodiments, an axial distance from an annular surface formed by the rotation of the second line segment to a solid-liquid interface in the crucible is d1, an axial length of the third line segment is h, and h= (1.0-1.5)d1, a radial width of the annular surface formed by the rotation of the second line segment is w, a radial distance between an ingot at the solid-liquid interface and the crucible is d2, and w= (1/4-1/3)d2.

In some embodiments, a radial distance D1 from an outer surface of the upper reflector part to an inner side wall of the crucible is between 5 mm and 15mm, a radial distance D2 from an inner surface formed by the rotation of the third line segment to the ingot is between 7mm and 15mm, a radial distance D3 from the outer surface of the upper reflector part to a lateral insulation structure is between 25mm and 35mm, and a radial distance D4 from an inner surface of the upper reflector part to the cooling jacket is between 3mm and 10mm.

According to another aspect of the present invention, an ingot growth method is provided. At an equal-diameter stage, the growth method includes: moving the cooling jacket in a direction close to or away from the crucible, and adjusting a measured diameter of the ingot, so that the measured diameter reaches a target diameter, wherein the measured diameter is an actual diameter of the ingot in growth, and the target diameter is a diameter set by the growth device.

In some embodiments, when a difference between the measured diameter and the target diameter is greater than a first set threshold, the cooling jacket moves a first distance h1 in a direction away from the crucible; when the difference between the measured diameter and the target diameter is less than a second set threshold, the cooling jacket moves a second distance h2 in a direction close to the crucible; and when the difference between the measured diameter and the target diameter is greater than or equal to the second set threshold and less than the first set threshold, the cooling jacket does not move, wherein the first set threshold is greater than the second set threshold.

In some embodiments, the first set threshold is Δ D1, the second set threshold is Δ D2, and Δ D1 and Δ D2 satisfy: 0.8mm ≤Δ D1≤ 1.2mm, and -1.2mm ≤Δ D2≤ -0.8mm.

In some embodiments, the first distance h1 satisfies: 4.5mm ≤h1≤ 5.5mm, and the second distance h2 satisfies: 4.5mm ≤h2≤ 5.5mm.

In some embodiments, a moving rate of the cooling jacket is less than 400mm/min.

By applying the technical solutions of the present invention, in the growth device, the cooling jacket moves in the axial direction of the crucible to affect the thermal field distribution in the furnace body, and the temperature gradient at the solid-liquid interface is finely adjusted, thereby pulling the ingot with a width defect-free growth region; and in the growth method, the movement of the cooling jacket in the axial direction of the crucible is adjusted according to the difference between the measured diameter and the target diameter, the actual diameter is controlled through the movement of the cooling jacket, so that the measured diameter is close to the target diameter, and it is easy to control the temperature gradient at the solid-liquid interface, which solves the problem of difficult control of the temperature gradient at the solid-liquid interface in the prior art, which leads to pull the ingot with more defects.

### Brief Description of the Drawings

The drawings, which constitute a part of the present invention, are used to provide a further understanding of the present invention, and illustrative embodiments of the present invention and descriptions thereof are used to explain the present invention, and do not constitute improper limitations to the present invention. In the drawings:
Fig. 1 shows a schematic structural diagram of an embodiment of an ingot growth device according to the present invention;
Fig. 2 shows a schematic diagram of a partial structure of Fig. 1;
Fig. 3 shows a schematic diagram of a partial structure of Fig. 1;
Fig. 4 shows a schematic diagram of a partial structure of Fig. 1;
Fig. 5 shows a schematic diagram of a simulation structure;
Fig. 6 shows a schematic diagram of a simulation result of CGSIM simulation software; and
Fig. 7 shows a schematic flow diagram of an ingot growth method according to the present invention.

The above drawings include the following reference signs:
10, furnace body; 20, heater; 30, crucible; 40, melt; 50, ingot; 60, cooling jacket; 70, reflector; 80, lateral insulation structure; 90, lifting device; 71, upper reflector part; 72, lower reflector part; 721, first line segment; 722, second line segment; 723, third line segment; 724, fourth line segment; 725, fifth line segment.

### Detailed Description of the Embodiments

It should be noted that, the following detailed description is illustrative, and is intended to provide a further description to the present invention. Unless otherwise specified, all technical and scientific terms used herein have the same meaning as commonly understood by those ordinary skilled in the art to which the present invention belongs.

It should be noted that, the terms used herein are only for describing specific embodiments and are not intended to limit exemplary embodiments according to the present invention. As used herein, singular forms are intended to include plural forms as well, unless the context clearly dictates otherwise. In addition, it should also be understood that when the terms "comprising" and/or "include" are used in the present specification, they means there are features, steps, operations, devices, components and/or combinations thereof.

It should be understood that, when an element (such as a layer, a film, an area or a substrate) is described as being "on" another element, the element may be directly on the other element, or an intervening element may also be present. Moreover, in the specification and claims, when an element is described as being "connected" to another element, the element may be "directly connected" to the other element, or "connected" to the other element through a third element.

In an existing ingot growth device, a cooling jacket is fixed, and its function is to accelerate cooling ingots, so as to increase the productivity. The cooling jacket is generally matched with a reflector, which separates a hot zone from a cold zone while dredging the flow of an internal gas, thereby affecting a temperature gradient at a solid-liquid interface. Once the positions of the cooling jacket and the reflector are fixed, the influence of the cooling jacket and the reflector on the temperature gradient at the solid-liquid interface is considered to be fixed, but at an equal-diameter stage, in order to make a measured diameter reach a target diameter, the temperature gradient at the solid-liquid interface needs to be adjusted.

Since the temperature gradient at the solid-liquid interface cannot be directly measured, it is difficult to control in an actual production process. In the prior art, the temperature gradient is generally confirmed by using indirect methods, such as thermal field simulation, or defect analysis performed on a growth ingot, a temperature gradient condition at the solid-liquid interface in an ingot growth process is reversely deduced according to an internal defect distribution of the ingot, then a thermal field is adjusted, the temperature at the interface is adjusted in a cyclic manner, so as to receive the ingot with a width defect-free region. In order to solve the above technical problems, it is necessary to adjust the temperature gradient at the solid-liquid interface in time, the inventor performs a large number of experimental researches and numerical simulations, during equal-diameter growth, when a control system measures that the measured diameter is greater than the target diameter, the cooling jacket is moved in a direction away from a crucible, so that the temperature gradient at the solid-liquid interface decreases, and the measured diameter is reduced after measurement; when the control system measures that the measured diameter is less than the target diameter, the cooling jacket is moved in a direction close to the crucible, so that the temperature gradient at the solid-liquid interface increases, and the measured diameter increases after measurement. That is, when the measured diameter measured by the control system is larger than or smaller than the target diameter, it is only necessary to move the cooling jacket to properly control the temperature at the solid-liquid interface, so that the measured diameter is close to the target diameter, and meanwhile, the temperature gradient at the solid-liquid interface is also adjusted in time.

Moreover, the relative position between the cooling jacket and the reflector also affects the flow direction and the flow rate of the gas in the furnace, and further affects the thermal field distribution in the furnace, in particular the temperature gradient at the solid-liquid interface. Argon enters from an upper part of the furnace body, flows downwards under a furnace pressure and gravity, and is discharged from a lower part of the furnace body after passing through a cooling jacket, a reflector, the crucible and a lateral heater.

The "defect-free region" in the ingot of the above-mentioned defect-free region allows the existence of a very small amount of one or more ingot defects, which is insufficient to cause a large change in a certain electrical or mechanical properties of an obtained wafer or the ingot, so as to degrade the performance of a manufactured electronic device.

According to the Voronkov theory, the defect-free region may only be grown when a V/G value is within a certain range. In order to stably grow the ingot with a width defect-free region, the influence of the growth speed V, which is the first essential element sensitive to defect growth, is reduced. When a fixed growth rate V is utilized, that is, the growth speed of the ingot V is constant, only an axial temperature gradient at the solid-liquid interface needs to be adjusted. In this regard, the inventor proposes some embodiments of the present invention according to the above discovery.

In order to solve the above technical problems, the present invention provides an ingot growth device and growth method.

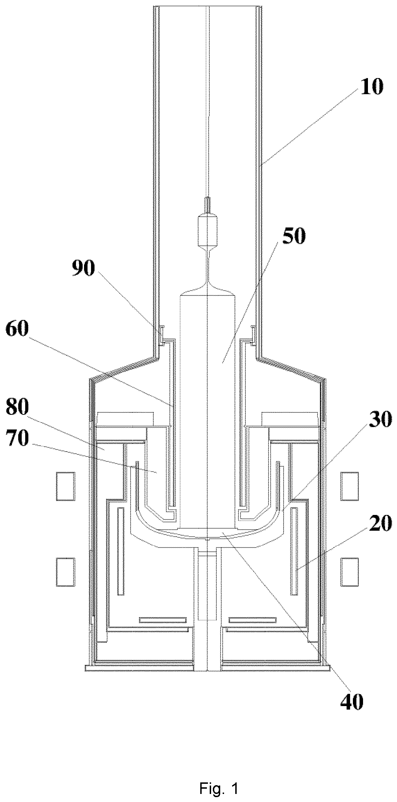

In an embodiment of the present invention, an ingot growth device is provided. As shown in Fig. 1 to Fig. 3, the device includes a furnace body 10, a heater 20, a crucible 30, an ingot 50, a cooling jacket 60 and a reflector 70,
the crucible 30 is arranged inside the furnace body 10 for containing melt;
the cooling jacket 60 is arranged inside the furnace body 10 and cools the ingot, the cooling jacket 60 is located above the crucible 30 and is on a horizontal plane perpendicular to a central axis of the crucible 30, and an orthographic projection of the cooling jacket 60 is located in an outer contour of an orthographic projection of the crucible 30;
the reflector 70 is arranged on a periphery of the cooling jacket 60, the reflector 70 is between the Ingot and the crucible 30, the reflector 70 includes an upper reflector part 71 and a lower reflector part 72, the upper reflector part 71 is cylindrical and surrounds the cooling jacket 60, the lower reflector part 72 is arranged at a lower end of the upper reflector part 71 and is located on a lower side of the cooling jacket 60, the lower reflector part 72 is of a hollow circular truncated cone structure with a large top and a small bottom, a groove is formed on an inner peripheral wall of the circular truncated cone structure, a top of the groove penetrates through the circular truncated cone structure, a side wall of the groove is a cylindrical surface, and a bottom wall of the groove is an annular surface; and
the cooling jacket 60 moves along an axial direction of the crucible 30.

In some embodiments of the present invention, the cooling jacket 60 moves along the axial direction of the crucible 30 and cooperates with the reflector 70. The cooling jacket 60 and the reflector 70 integrally affect a thermal field distribution in the furnace body 10, and also affect the flow and rate of the gas flow in the furnace to a certain extent, which in turn affects a temperature gradient at the solid-liquid interface. Therefore, by adjusting the relative position between the cooling jacket 60 and the reflector 70, the temperature gradient at the interface is controlled.

In this embodiment, the lower reflector part is formed a rotator, wherein the bottom wall of the groove is a torus, and a longitudinal section of the rotator may be rectangular, semicircular, triangular and the like. When the gas flow above the furnace body passes through the bottom wall of the lower reflector part, a cross section of a gas flow channel becomes small, a rate of the gas flow increases, the gas flow accelerates, then, when the gas flow flows through the outer surface of the lower reflector part and flows through a circular truncated cone surface of the outer surface, more gas flow is instantaneously released, thereby preventing the formation of vortex, improving the gas discharge efficiency, and preventing the deposition of impurity gases from affecting the quality of the ingot. Therefore, the circular truncated cone surface on the outer surface of the lower reflector part can better guide the flow of the gas flow and take away more impurity gases.

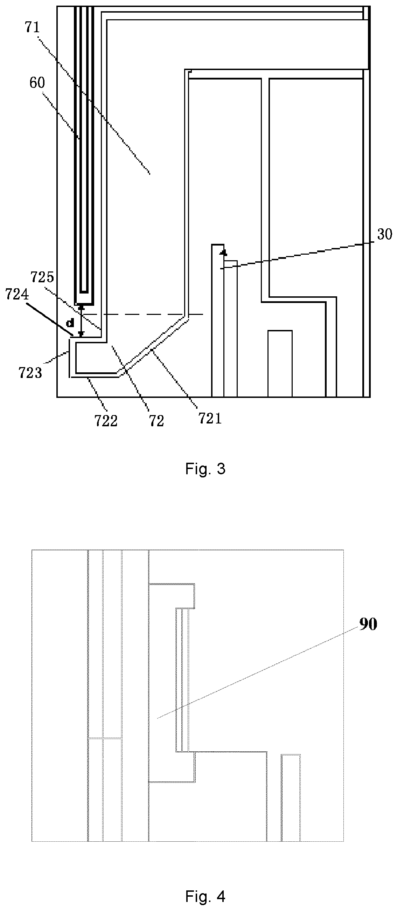

In addition, any device in the prior art that can control the movement of the cooling jacket is acceptable, such as, a hydraulic lifting device or chain-driven lifting device 90, etc. As shown in Fig. 4, the ingot growth device also includes a lifting device 90 with a slide rail, and a movement of the cooling jacket is controlled by controlling the operation of the lifting device 90.

In an embodiment, an axial distance between the cooling jacket and the bottom wall of the groove in the crucible is 13 mm -93mm, and the distance may be recorded as d. By controlling the distance between the two within this range, the temperature gradient at the solid-liquid interface can be better controlled to prevent a relatively large change in the temperature gradient at the interface.

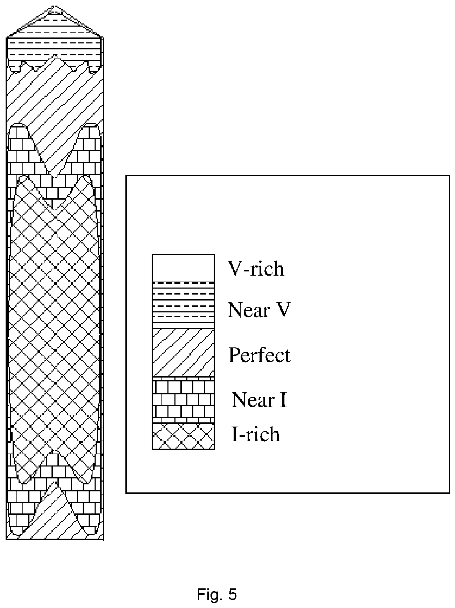

In particular, when the distance between the cooling jacket and the bottom wall of the groove in the axial direction of the crucible is 13mm, a pulling speed of the ingot is very slow and almost unchanged, and an internal defect distribution map of the ingot is obtained through simulation, as shown in Fig. 5 for details. Among the marks in the figure, Near V and Near I represent fewer intrinsic defects, Near V represents fewer vacancy defects, and Near I represents fewer interstitial defects, the regions of Near V and Near I may be approximately considered as defect-free regions, V-rich and I-rich represent more intrinsic defects, V-rich represents more vacancy defects, I-rich represent more interstitial defects, and since the pulling speed is very slow, there is no V-rich region in the simulation map. Therefore, the defect-free region is relatively wide in the Fig. 5, that is, Perfect, Near V and Near I regions, the defect-free region specifically refers to virtual frame annotation in the figure, which accounts for about 30% of the entire ingot length.

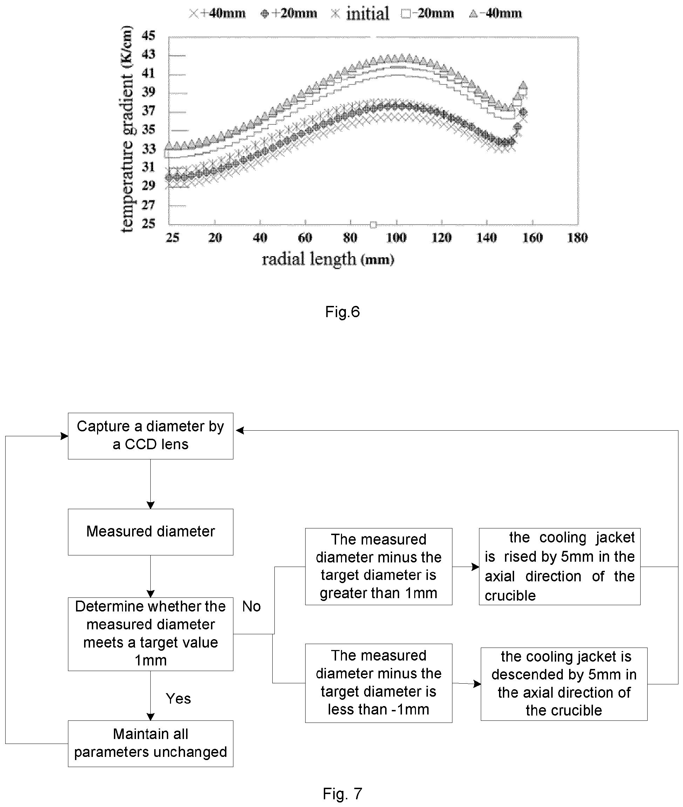

In order to verify the correspondence relationship between the movement of the cooling jacket and the temperature gradient at the solid-liquid interface, the inventor uses CGSIM simulation software for simulation, the result is shown in Fig. 6. In this figure 6, +40mm indicates that the cooling jacket rises by 40mm with respect to an initial position, and +20 mm indicates that the cooling jacket rises by 20mm with respect to the initial position, -40mm indicates that the cooling jacket declines by 40mm with respect to the initial position, and -20mm indicates that the cooling jacket declines by 20mm with respect to initial position. It can be seen from the figure in the range of -40mm to 40mm, with the increase of the moving distance of the cooling jacket along the direction away from the crucible, the temperature gradient at the solid-liquid interface slightly decreases, and ΔG is about 4K/cm.

Therefore, when the axial distance between the cooling jacket and the bottom wall of the groove in the crucible is 13mm -93mm, which can better control the temperature gradient at the solid-liquid interface and ensure that an Ingot with a width defect-free region can be drawn, which solves the problem that it is difficult to control the temperature gradient at the solid-liquid interface in the prior art.

In the embodiment of the present invention, the cooling jacket includes a shell and a water flow channel located inside the shell, and a width of the water flow channel is between 5mm and15mm. The cooling jacket is filled with water in the water flow channel, which can cool the ingot faster, the productivity is improved, and also affect the distribution of the thermal field in the furnace. Therefore, then the cooling jacket moves along the axial direction of the crucible and the water flow channel inside it also changes accordingly, so that the temperature gradient at the solid-liquid interface is fine-tuned.

As shown in Fig. 3, in one embodiment, the lower reflector part 72 is formed into a rotator, and a longitudinal section of the lower reflector part 72 includes a first line segment 721, a second line segment 722, a third line segment 723, a fourth line segment 724 and a fifth line segment 725, which are connected in sequence, wherein the first line segment 721 corresponds to an outer peripheral wall of the circular truncated cone structure and is formed into an oblique segment, the fourth line segment 724 corresponds to the bottom wall of the groove and is parallel to the second line segment 722, the fifth line segment 725 corresponds to the side wall of the groove and is vertically arranged with the third line segment 723, and the second line segment 722 and the fourth line segment 724 intersect perpendicularly the third line segment 723, respectively.

Then, the second line segment 722, the third line segment 723 and the fourth line segment 724, which are connected in sequence, rotate along the axis of the crucible 30 to form an annular cylinder. When the gas in the furnace flows through the annular cylinder, the gas flow rate at each point inside is the same, so that the gas flow is smooth, and there will be no vortex and accumulation.

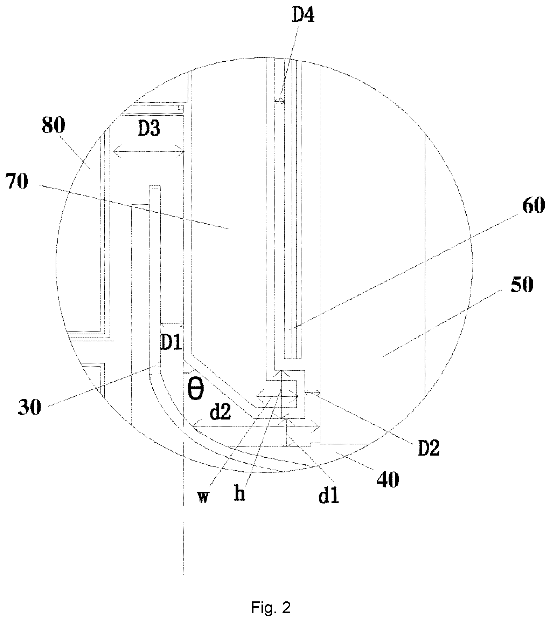

In an embodiment, an included angle θ between the first line segment and the central axis of the crucible 30 is 40°-80°, specifically as shown in Fig. 2. The design of the outer peripheral wall of the lower reflector part may better play a flow guide role and efficiently taking away impurity gases (such as CO, SiO). If the included angle between the first line segment and the central axis of the crucible 30 is less than 40°, when the gas in the furnace flows through the circular truncated cone surface on the outer surface of the lower reflector part, vortex is generated to affect the flow of the gases, which cause the impurity gases to deposit in the reflector 70, thus affecting the quality of the ingot; and if the included angle between the first line segment and the central axis of the crucible 30 is greater than 80°, most gases in the furnace accumulate at a lower part of the lower reflector part, which will affect the furnace pressure, and cause a difficulty in gas discharge.

In an embodiment of the present invention, an axial distance from an annular surface formed by the rotation of the second line segment to a solid-liquid interface in the crucible is d1, an axial length of the third line segment is h, and h=(1.0-1.5)d1, the radial width of the annular surface formed by the rotation of the second line segment is w, a radial distance between the Ingot at the solid-liquid interface and the crucible is d2, and w= (1/4-1/3)d2.

The position of the lower reflector part designed in the above solution is just close to a meniscus of the melt, since the temperature at the meniscus is higher, the lower reflector part just separates a hot zone at the meniscus from a cold zone and homogenizes a radial temperature gradient at the solid-liquid interface. The nonuniform radical temperature gradient of the interface also causes excessive changes in the axial temperature gradient and sudden changes in the shape of the liquid surface, and affects the quality of the ingot. In order to achieve a better thermal insulation effect, the upper reflector part can be filled with some thermal insulation materials, such as hard felt, soft felt carbon fibers or the like, and its outer surface may be coated with an insulation layer, such as a molybdenum layer, a graphite layer, or the like.

Wherein, the meniscus is an area in which the melt level is adsorbed below the ingot due to capillary action by surface tension, that is, the area formed between an ingot growth surface and the melt level. For example, for a silicon single ingot, the meniscus is an intersection of a solid phase and a liquid phase, and the temperature is about 1410°C.

In a specific embodiment of the present invention, as shown in Fig. 2, a radial distance D1 from an outer surface of the upper reflector part to an inner side wall of the crucible 30 is between 5mm and15mm, a radial distance D2 from an inner surface formed by the rotation of the third line segment to the Ingot is between 7mm and15mm, a radial distance D3 from the outer surface of the upper reflector part to a lateral insulation structure 80 is between 25 mm and 35mm, and a radial distance D4 from an inner surface of the upper reflector part to the cooling jacket 60 is between 3mm and10mm. Due to the arrangement of the position of the reflector, the reflector 70 almost occupied the space between the crucible 30 and the ingot, thereby separating the hot zone from the cold zone, and better controlling the temperature gradient at the solid-liquid interface to be stable within a certain range, and then an ingot with a sufficiently wide defect-free region can be drawn; and the gas flow in the furnace is smoothly guided along the shape of the lower reflector part and quickly passes through the lower reflector part, so as to take away most impurity gases (SiO, CO and the like), and thus, the quality of the ingot is improved.

In another typical embodiment of the present invention, an ingot growth method is proposed. At an equal-diameter stage, the growth method includes: moving the cooling jacket in a direction close to or away from the crucible, and adjusting a measured diameter of the ingot, so that the measured diameter reaches a target diameter, wherein the measured diameter is an actual diameter during the ingot growth, and the target diameter is a diameter set by the growth device.

In the embodiment, in order to clarify the relationship between the moving distance of the cooling jacket and diameter control, the ingot growth method is disclosed.

When a difference between the measured diameter and the target diameter is greater than a first set threshold, the cooling jacket moves away from the crucible by a first distance h1;
when the difference between the measured diameter and the target diameter is less than a second set threshold, the cooling jacket moves a second distance h2 toward the crucible; and
when the difference between the measured diameter and the target diameter is greater than or equal to the second set threshold and less than the first set threshold, the cooling jacket does not move.

The first set threshold is Δ D1, the second set threshold is Δ D2, and Δ D1 and Δ D2 satisfy: 0.8mm ≤Δ D1≤ 1.2mm, and -1.2mm ≤Δ D2≤ -0.8mm.

At an equal-diameter production stage of actual production, the first set threshold and the second set threshold are not within the above range, that is, the difference between the measured diameter and the target diameter is very large, the measured diameter cannot be adjusted to the target diameter just by adjusting the cooling jacket, this diameter is generally adjusted by adjusting the pulling speed and the heater. Therefore, the first set threshold and the second set threshold are within the above range, which make the measured diameter close to the target diameter through the movement of the cooling jacket along the axial direction of the crucible.

According to the difference between the measured diameter and the target diameter, the moving direction and the moving distance of the cooling jacket along the axial direction of the crucible are directly adjusted, and meanwhile, the temperature gradient at the solid-liquid interface may also be conveniently controlled, so that the V/G value is within a reasonable range. An Ingot with a sufficiently wide defect-free region is grown.

In one embodiment, the first distance h1 satisfies: 4.5mm ≤h1≤ 5.5mm, and the second distance h2 satisfies: 4.5mm ≤h2≤ 5.5mm.

In one embodiment, the moving rate of the cooling jacket is less than 400mm/min.

By controlling a stable temperature gradient at the solid-liquid interface, a stable interface shape and pulling speed are obtained, so that the radial defect of the entire Ingot is remain stable. In order to improve the quality of the ingot, according to the simulation, it can be known that when the cooling jacket rises by 40mm, the temperature gradient at the solid-liquid interface is reduced by about 2K/cm, and the temperature change of the cooling jacket is about 0.5 degrees Celsius every 10 mm moving, and a temperature disturbance range at the solid-liquid interface cannot exceed 20 degrees Celsius, and the up and down movement of the cooling jacket cannot exceed 400mm. In order to reduce the generation of stress and dislocation in the Ingot, the moving rate of the cooling jacket should not exceed 400mm/min.

### Embodiment 1

In the growth process of the Ingot, the furnace pressure in the furnace body is controlled to be 20-50torr, an argon flow rate in the furnace body is controlled to be greater than 120slpm, the rotating speed of the Ingot is controlled to be 12±2rpm, the rotating speed of the crucible is controlled to be 0.2±0.1rpm, and the rotating direction of the Ingot is opposite to that of the crucible. Under the above production parameters, the diameter of the Ingot is better controlled by using the Ingot growth method of the present invention, so that the measured diameter is about the target diameter, and the specific process is shown in Fig. 7.

The specific process is as follows:
Capturing a diameter by a CCD lens to obtain a measured diameter, and determining whether the measured diameter meets the target value within 1 mm;
when the measured diameter does not meet the target value within 1 mm, When the difference between the measured diameter and the target diameter is greater than a first set threshold 1mm, that is, the measured diameter minus the target diameter is greater than 1mm, lifting the cooling jacket by 5mm along the axial direction of the crucible, that is, moving the cooling jacket a first distance 5mm away from the axial direction crucible;
when the difference between the measured diameter and the target diameter is less than a second set threshold -1mm, that is, the measured diameter minus the target diameter is less than -1mm, lowering the cooling jacket by 5mm along the axial direction of the crucible, that is, moving the cooling jacket by a second distance 5mm toward the axial direction of the crucible;
when the difference between the measured diameter and the target diameter is greater than the second set threshold and less than the first set threshold, the cooling jacket does not move; and
when the measured diameter meets the target value within 1mm, maintaining all the parameters unchanged, and remeasuring the diameter;
wherein, Δ D1= 1mm, Δ D2= -1mm, h1= 5mm, and h2= 5mm.

In the ingot growth method of the present invention, the diameter of the ingot is measured in real time, but the above ingot growth method needs to be matched with a control system, and the control system needs a certain time to process information, that is, the diameter of the ingot is measured after a certain time, which is also within the protection scope of the growth method of the present invention.

In the above embodiments of the present invention, the descriptions of the various embodiments have different focuses, and parts that are not described in a certain embodiment in detail may refer to related descriptions in other embodiments.

In summary, the technical solutions of the present invention may achieve the following effects:
1) In the ingot growth device of the present invention, the cooling jacket therein moves along the axial direction of the crucible, which affects the thermal field distribution in the furnace body, and can fine-tune the temperature gradient of the solid-liquid interface, thereby pulling the ingot with a width defect-free region. This invention solves the problem that the temperature gradient at the solid-liquid interface is difficult to control in the prior art, which lead to pull the ingot in growth regions with more defects.
2) In the ingot growth method of the present invention, according to the difference between the measured diameter and the target diameter, the moving direction and the moving distance of the cooling jacket along the axial direction of the crucible can be adjusted. The movement of the cooling jacket not only realizes the measured diameter is close to the target diameter, but also adjusts the temperature gradient at the solid-liquid interface to grow the ingot with a defect-free region as wide as possible. In conclusion, by measuring the difference between the measured diameter and the target diameter, the temperature gradient at the solid-liquid interface is conveniently controlled, it is convenient to ensure that the ratio V/G of the ingot growth speed V to the axial temperature at the solid-liquid interface is within a reasonable range, and an ingot with a width defect-free region is produced.

The above descriptions are only embodiments of the present invention, and are not intended to limit the present invention. For those skilled in the art, the present invention may have various changes and modifications. Any modifications, equivalent replacements, improvements and the like, made within the spirit and principles of the present invention, shall be included within the protection scope of the present invention.

## Claims

1. An ingot growth device, comprising a furnace body, a crucible, a cooling jacket and a reflector,
the crucible is arranged inside the furnace body for containing melt;
the cooling jacket is arranged inside the furnace body to cool the ingot, the cooling jacket is located above the crucible and is on a horizontal plane perpendicular to a central axis of the crucible, and an orthographic projection of the cooling jacket is located in an outer contour of an orthographic projection of the crucible;
the reflector is arranged on a periphery of the cooling jacket, the reflector comprises an upper reflector part and a lower reflector part, the upper reflector part is cylindrical and surrounds the cooling jacket, the lower reflector part is arranged at a lower end of the upper reflector part and is located on a lower side of the cooling jacket, the lower reflector part is of a hollow circular truncated cone structure with a large top and a small bottom, a groove is formed on an inner peripheral wall of the circular truncated cone structure, a top of the groove penetrates through the circular truncated cone structure, a side wall of the groove is a cylindrical surface, and a bottom wall of the groove is an annular surface;
wherein, the cooling jacket moves along an axial direction of the crucible.

2. The ingot growth device according to claim 1, wherein an axial distance between the cooling jacket and the bottom wall of the groove in the crucible is 13 mm -93mm.

3. The ingot growth device according to claim 1, wherein the cooling jacket comprises a shell and a water flow channel located inside the shell, and a width of the water flow channel is 5 mm -15 mm.

4. The ingot growth device according to claim 3, wherein the lower reflector part is formed a rotator, and a longitudinal section of the lower reflector part comprises a first line segment, a second line segment, a third line segment, a fourth line segment and a fifth line segment, which are connected in sequence, wherein the first line segment corresponds to an outer peripheral wall of the circular truncated cone structure and is formed into an oblique segment, the fourth line segment corresponds to the bottom wall of the groove and is parallel to the second line segment, and the fifth line segment corresponds to the side wall of the groove and is vertically arranged with the third line segment.

5. The ingot growth device according to claim 4, wherein the second line segment and the fourth line segment intersect perpendicularly to the third line segment, respectively.

6. The ingot growth device according to claim 4, wherein an included angle θ between the first line segment and the central axis of the crucible is 40° -80° .

7. The ingot growth device according to claim 5, wherein,
an axial distance from an annular surface formed by the rotation of the second line segment to a solid-liquid interface in the crucible is d1, an axial length of the third line segment is h, and h= (1.0-1.5)d1, a radial width of the annular surface formed by the rotation of the second line segment is w, a radial distance between an ingot at the solid-liquid interface and the crucible is d2, and w= (1/4-1/3)d2.

8. The ingot growth device according to any one of claims 1-7, wherein a radial distance D1 from an outer surface of the upper reflector part to an inner side wall of the crucible is between 5 mm and 15mm, a radial distance D2 from an inner surface formed by the rotation of the third line segment to the ingot is between 7 mm and 15mm, a radial distance D3 from the outer surface of the upper reflector part to a lateral insulation structure is between 25 mm and 35mm, and a radial distance D4 from an inner surface of the upper reflector part to the cooling jacket is between 3mm and 10mm.

9. An ingot growth method, wherein the growth device according to any one of claims 1-8 is used, and at an equal-diameter stage, the growth method comprises:
moving the cooling jacket in a direction close to or away from the crucible, and adjusting a measured diameter of the ingot, so that the measured diameter reaches a target diameter,
wherein the measured diameter is an actual diameter of the ingot in growth, and
the target diameter is a diameter set by the growth device.

10. The ingot growth method according to claim 9, wherein,
when a difference between the measured diameter and the target diameter is greater than a first set threshold, the cooling jacket moves a first distance h1 in a direction away from the crucible;
when the difference between the measured diameter and the target diameter is less than a second set threshold, the cooling jacket moves a second distance h2 in a direction close to the crucible; and
when the difference between the measured diameter and the target diameter is greater than or equal to the second set threshold and less than the first set threshold, the cooling jacket does not move,
wherein the first set threshold is greater than the second set threshold.

11. The ingot growth method according to claim 10, wherein the first set threshold is Δ D1, the second set threshold is Δ D2, and Δ D1 and Δ D2 satisfy: 0.8mm ≤ Δ D1≤ 1.2mm, and -1.2mm ≤ Δ D2≤ -0.8mm.

12. The ingot growth method according to claim 11, wherein the first distance h1 satisfies: 4.5mm ≤h1≤ 5.5mm, and the second distance h2 satisfies: 4.5mm ≤h2≤ 5.5mm.

13. The ingot growth method according to claim 10, wherein a moving rate of the cooling jacket is less than 400mm/min.
